Europäisches Patentamt

European Patent Office

Office européen des brevets

(19)

(11) Publication number: **0 193 998**
**B1**

(12) # EUROPEAN PATENT SPECIFICATION

(45) Date of publication of patent specification: **21.06.89**

(51) Int. Cl.⁴: **C 23 C 16/32**

(21) Application number: **86200336.5**

(22) Date of filing: **04.03.86**

(54) **Method of depositing on a substrate a layer which consists substantially of silicon carbide.**

(30) Priority: **07.03.85 NL 8500645**

(43) Date of publication of application:
**10.09.86 Bulletin 86/37**

(45) Publication of the grant of the patent:
**21.06.89 Bulletin 89/25**

(84) Designated Contracting States:
**AT DE FR GB NL SE**

(56) References cited:

**JOURNAL OF THE AMERICAN CERAMIC
SOCIETY, vol. 66, no. 8, August 1983, pages
558-566; A.I. KINGON et al.: "Thermodynamic
calculations for the chemical vapor deposition
of silicon carbide"**

(73) Proprietor: **N.V. Philips' Gloeilampenfabrieken
Groenewoudseweg 1
NL-5621 BA Eindhoven (NL)**

(72) Inventor: **Jensma, Jacob Pieter c/o INT.
OCTROOIBUREAU B.V.
Prof. Holstlaan 6
NL-5656 AA Eindhoven (NL)**
Inventor: **Verspui, Gerrit c/o INT.
OCTROOIBUREAU B.V.
Prof. Holstlaan 6
NL-5656 AA Eindhoven (NL)**

(74) Representative: **Auwerda, Cornelis Petrus et al
INTERNATIONAAL OCTROOIBUREAU B.V. Prof.
Holstlaan 6
NL-5656 AA Eindhoven (NL)**

(56) References cited:
**CHEMICAL ABSTRACTS, vol. 89, no. 18, 30th
October 1978, page 275, no. 151345e,
Columbus, Ohio, US; J.I. FEDERER:
"Deposition of silicon carbide coatings on
particles in a fluidized bed using silane and
tetramethylsilane: a feasibility study", &
REPORT 1978, ORNL/TM-6185**

EP 0 193 998 B1

(56) References cited:

JOURNAL OF THE AMERICAN CERAMIC
SOCIETY, vol. 65, no. 7, July 1982, pages
324-330; W.R. CANNON et al.: "Sinterable
ceramic powders from laser-driven reactions: I,
process description and modeling"

JOURNAL OF THE ELECTROCHEMICAL
SOCIETY: SOLID STATE SCIENCE, vol. 118, no.
2, February 1971, pages 338-340; J.M. HARRIS
et al.: "Growth characteristics of alpha-silicon
carbide"

IEEE TRANSACTIONS ON NUCLEAR SCIENCE,
vol. NS-28, no. 2, April 1981, pages 1838-1840,
IEEE, New York, US; D.D. ALLRED et al.: "The
hydrogen content of multicompponent
amorphous silicon alloys by 19F nuclear
reaction analysis"

J. SCHLICHTING et al.: "Gmelin handbook of
inorganic chemistry - Si, Silicon", supplement
vol. B2, system no. 15, 1984, Springer-Verlag,
Berlin, DE

## Description

The invention relates to a method of depositing on a substrate a layer which consists substantially of silicon carbide (SiC) by causing a gaseous mixture of a silicon compound and a carbon compound to react with each other at elevated temperature in a reactor in which the substrate to be coated is present.

A layer which consists substantially of SiC is to be understood to mean herein a layer the composition of which differs little from the stoichiometric composition.

The deposition of layers which consist substantially of SiC by means of a thermal CVD-process is known per se. Processes are known which are carried out at temperatures above 1,000°C and at atmospheric or higher pressure. In high-temperature processes the choice of the substrate material is restricted. In processes which are carried out at atmospheric or higher pressure, homogeneous layers are difficult to deposit. In processes in which halides of silicon are used, the corrosive character of halogen compounds formed in the reaction (for example, HCl when $SiCl_4$ or other chlorine-containing silicon compounds or carbon compounds are used) must be taken into account in the choice of the substrate material.

It is therefore the object of the invention to provide a method which can be carried out at temperatures up to 1,000°C and at low pressure and in which no halogen or halogen compounds are formed and with which hard, adhering and homogeneous SiC-layers are obtained.

According to the invention, this object is achieved by means of a method which is characterized in that a gaseous mixture which contains $SiH_4$ and $C_2H_4$ is heated in the reactor to a temperature between 700 and 1,000°C at a pressure between 25 and 125 Pa. The gas mixture may additionally contain a carrier gas, for example, argon or hydrogen or a mixture of both gases.

During the investigation which led to the invention it was found that hard, homogeneous and adhering layers of SiC can be deposited on hard metal and various types of steel which contain approximately 49 to 56 at.% of silicon, the quantity of free silicon and free carbon, respectively, being comparatively small.

The molar ratio of $SiH_4$ to $C_2H_4$ in the gas mixture is preferably between 0.4 and 4. It has been found that the composition of the deposited layer is little influenced within these limits. It has been found that a high molar ratio of $SiH_4$ to $C_2H_4$ can influence the layer thickness of the deposited SiC layers over the length of the reactor. With the molar ratio of $SiH_4$ to $C_2H_4$ between 0.4 and 0.6, however, said influence is acceptable for most applications (difference less than 40% over 50 cm). The growth rate of the layers also decreases at temperatures below 700°C. Practically useful growth rates of approximately 1 μm (micrometres) and more per hour are found at temperatures between 800 and 950°C. Between 850 and 900°C an SiC layer is obtained in which the Si-content in at.% is between 49 and 56 at.%.

The growth rate is also influenced by the pressure used. When the pressure increases, the growth rate also increases. Above 125 Pa, however, the significance of a homogeneous gaseous phase reaction begins to become greater as a result of which the growth rate decreases again. The resulting SiC layers are polycrystalline, the crystallites have a hexagonal structure.

The deposited SiC layers adhere particularly readily to all kinds of hard metals. To obtain a good adhesion to steel substrates it may be necessary to deposit a thin adhering layer consisting of titanium nitride before SiC is deposited (thickness TiN layer: 1 μm).

The method according to the invention will now be described in greater detail with reference to the ensuing specific examples.

Example 1
Hard metal chisels (type THF from Krupp, 94% WC, 4% Co, 2% other carbides (TiC/TaC/NbC)) are placed in a low-pressure reactor. After the reactor has been brought to sub-ambient pressure, the temperature is adjusted to 850°C while flushing with 200 sccm of $H_2$ per minute. When 850°C is reached, 30 ml of $SiH_4$ and 30 sccm of $C_2H_4$ per minute are admitted to the reactor at a pressure of 0.5 mbar (50 Pa). After 2½ hours a 5 μm thick SiC layer is deposited on the chisels (1 sccm at 76 cm and 20°C).

Example 2
A steel electrochemical machining (ECM) electrode (St 33-1 according to 17100) is placed in the reactor and is first covered with an adhering intermediate layer of TiN (850°C, 900 mbar 4% $TiCl_4$, remainder $N_2+H_2$ 1:1 for 60 minutes until a thickness of 1 μm). As in Example 1, a 5 μm thick SiC layer is then deposited. An insulating $Si_3N_4$ layer is then deposited on the electrode starting from a gas mixture of $SiH_2Cl_2+NH_3$ at 850°C and a pressure of 0.5 mbar. 200 sccm/minute of $NH_3$ and 25 sccm/minute of $SiH_2Cl_2$ are then admitted for 30 minutes, after which a 0.5 μm thick $Si_3N_4$ layer has formed. A 5 μm thick SiC layer is deposited over this layer according to Example 1 so that totally an $SiC$-$Si_3N_4$-$SiC$ triple layer is obtained. Such a layer can successfully be used as an insulation on an ECM-electrode.

## Claims

1. A method of depositing on a substrate a layer which consists substantially of SiC by causing a gaseous mixture of a silicon compound and a carbon compound to react with each other at elevated temperature in a reactor in which the substrate to be coated is present, characterized in that a gaseous mixture which contains $SiH_4$ and $C_2H_4$ is heated in the reactor to a temperature between 700 and 1,000°C at a pressure between 25 and 125 Pa.

2. A method as claimed in Claim 1, characterized in that the molar ratio of SiH$_4$ to C$_2$H$_4$ in the gaseous mixture is between 0.4 and 4.

3. A method as claimed in Claim 1, characterized in that the molar ratio of SiH$_4$ to C$_2$H$_4$ in the gaseous mixture is between 0.4 and 0.6.

4. A method as claimed in Claim 1, characterized in that the temperature to which the gaseous mixture is heated is between 800 and 950°C.

5. A method as claimed in Claim 1, characterized in that the temperature to which the gaseous mixture is heated is between 850 and 900°C.

**Patentansprüche**

1. Verfahren zum Abscheiden einer im wesentlichen aus SiC bestehenden Schicht auf einem Substrat, und wobei in einem Reaktor, in dem sich das zu bedeckende Substrat befindet, ein gasförmigen Gemisch aus einer Siliciumverbindung und einer Kohlenstoffverbindung bei erhöhter Temperatur zur Reaktion gebracht wird, dadurch gekennzeichnet, dass in dem Reaktor ein gasförmigen Gemisch, das SiH$_4$ und C$_2$H$_4$ enthält, bis zu einer Temperatur zwischen 700 und 1000°C bei einem Druck zwischen 25 und 125 Pa erhitzt wird.

2. Verfahren nach Anspruch 1, dadurch gekennzeichnet, dass das Molverhältnis von SiH$_4$ zu C$_2$H$_4$ in dem Gasgemisch zwischen 0,4 und 4 liegt.

3. Verfahren nach Anspruch 1, dadurch gekennzeichnet, dass das Molverhältnis von SiH$_4$ zu C$_2$H$_4$ in dem Gasgemisch zwischen 0,4 und 0,6 liegt.

4. Verfahren nach Anspruch 1, dadurch gekennzeichnet, dass die Temperatur, auf die das Gasgemisch erhitzt wird, zwischen 800 und 950°C liegt.

5. Verfahren nach Anspruch 1, dadurch gekennzeichnet, dass die Temperatur, auf die das Gasgemisch erhitzt wird, zwischen 800 und 900°C liegt.

**Revendications**

1. Procédé pour déposer sur un substrat une couche essentiellement constituée par du carbure de silicium (SiC) par réaction d'un mélange gazeux d'un composé de silicium et d'un composé de carbone à une température élevée dans un réacteur contenant le substrat à revêtir, caractérisé en ce qu'un mélange gazeux contenant SiH$_4$ et C$_2$H$_4$ est chauffé dans le réacteur jusqu'à une température comprise entre 700 et 1000°C sous une pression située entre 25 et 125 Pa.

2. Procédé selon la revendication 1, caractérisé en ce que le rapport molaire SiH$_4$: C$_2$H$_4$ dans le mélange gazeux se situe entre 0,4 et 4.

3. Procédé selon la revendication 1, caractérisé en ce que le rapport molaire SiH$_4$: C$_2$H$_4$ dans le mélange gazeux se situe entre 0,4 et 0,6.

4. Procédé selon la revendication 1, caractérisé en ce que la température à laquelle est chauffé le mélange gazeux est comprise entre 800 et 950°C.

5. Procédé selon la revendication 1, caractérisé en ce que la température à laquelle est chauffé le mélange gazeux est comprise entre 850 et 900°C.